Europäisches Patentamt

European Patent Office

Office européen des brevets

(11) Publication number : **0 648 011 A1**

## (12) EUROPEAN PATENT APPLICATION

(21) Application number : **94306383.4**

(22) Date of filing : **31.08.94**

(51) Int. Cl.⁶ : **H03F 3/45**

(30) Priority : **10.09.93 GB 9318836**

(43) Date of publication of application :
**12.04.95 Bulletin 95/15**

(84) Designated Contracting States :
**DE FR**

(71) Applicant : **PLESSEY SEMICONDUCTORS LIMITED**
**Cheney Manor**
**Swindon, Wiltshire SN2 2QW (GB)**

(72) Inventor : **Madni, Arshad**
**17 Priory Road,**
**Park South**
**Swindon, Wiltshire, SN3 2HA (GB)**

(74) Representative : **Hoste, Colin Francis**
**The General Electric Company p.l.c.**
**GEC Patent Department**
**Waterhouse Lane**
**Chelmsford, Essex CM1 2QX (GB)**

(54) **Amplifier arrangements.**

(57)   An amplifier arrangement comprising a plurality of similar amplifier stages to which input signal voltages are applied in common, the output signal voltages being summed to retain bandwidth at the expense of gain compared with cascaded stages. The individual stages of the arrangement may be cascoded amplifier stages.

Fig. 2.

EP 0 648 011 A1

The present invention relates to amplifier arrangement, and in particular to amplifier arrangements comprising a plurality of amplifier stages.

According to one aspect of the present invention an amplifier arrangement comprises a plurality of amplifier stages to which input signal voltages are applied in common and means to sum the output signal voltages of said amplifier stages.

According to another aspect of the present invention an amplifier arrangement comprises at least two amplifier stages to which input signal voltages are applied in common and output load means, output signal voltages from one of said two amplifier stages being arranged to be developed at one terminal of said load means and output signal voltages from the other of said two amplifier stages being arranged to be developed across said load means, whereby the sum of said output signals is developed at the other terminal of said load means.

Each of said amplifier stages may comprise one half of a respective long tail pair stage to respective inputs of which said input signal voltages are applied in antiphase, said output signal voltages being derived in antiphase from respective output load means.

Amplifier arrangements in accordance with the present invention will now be described with reference to the accompanying drawings, of which:-

Figure 1 shows an amplifier arrangement schematically, and

Figure 2 shows another arrangement diagrammatically.

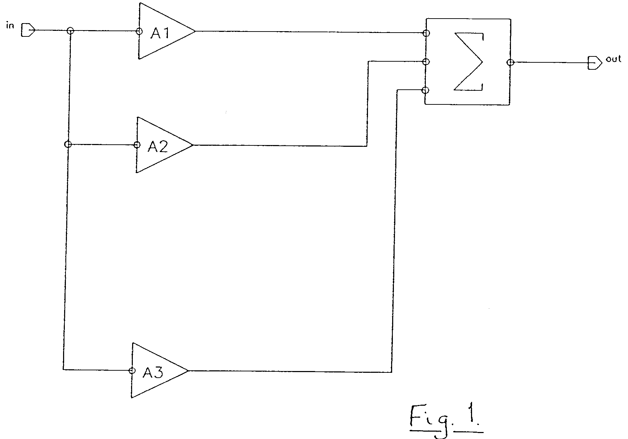

Referring to Figure 1, a plurality of amplifier stages A1, A2, A3 receiving input signals in common each provide voltage gain with a given bandwidth, and their output signals are summed. The overall voltage gain Gv of the arrangement may be represented as:-

$$Gv = f(\Sigma) \sum_i A_i \frac{1}{\prod_i (1 + st_i)}$$

- where $f(\Sigma)$ is the transfer function of the summing block, $A_i$ are the mid-band gains of the amplifiers A1, A2 etc., and $t_i$ are time constants of the amplifiers related to their bandwidths.

In the case of cascaded amplifiers stages the overall transfer function would be:-

$$Gv = \prod_i A_i \left( \frac{1}{1 + st_i} \right)$$

It can be seen that the overall bandwidth achieved with the cascaded amplifier stages is lower than that achieved from gain summing.

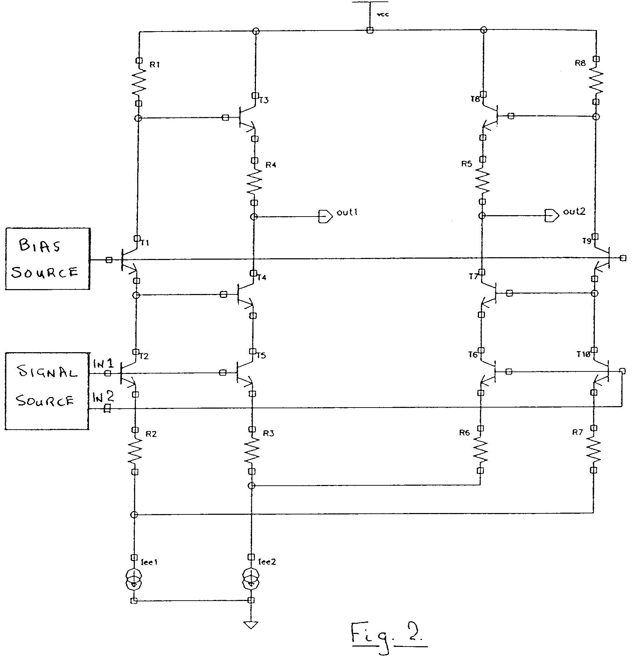

Referring to Figure 2, a summing arrangement for two amplifier stages is shown, each stage comprising a cascoded long tail pair transistor amplifier. One stage is formed by transistors T1, T2, T9 and T10, with load resistors R1 and R8, and the other by transistors T4, T5, T6 and T7 with load resistors R4 and R5. Emitter followers T3 and T8 apply the output voltage signals from the stage comprising the transistors T1, T2 and T9, T10, developed across resistors R1 and R8, to the top ends or terminals of resistors R4 and R5 respectively, while the output voltage signals from the stage comprising the transistors T4, T5 and T6, T7 are developed across these load resistors R4 and R5. Thus the sum of the output voltages developed in the two stages in response to input voltages applied at the terminals In1 and In2 appear at the terminals Out1 and Out2.

If a third amplifier stage (not shown) is used, it will be appreciated that the output voltage signals at the terminals Out1 and Out2 may be applied by way of respective emitter follower stages (not shown) to the top ends of the load resistors (not shown) of that third stage, the sum of the three output voltage signals being obtained at the other end of these load resistors.

It will further be appreciated that gain summing in accordance with the present invention may be achieved with circuits other than cascoded long tail pairs.

## Claims

1. An amplifier arrangement comprising a plurality of amplifier stages to which input signal voltages are applied in common and means to sum the output signal voltages of said amplifier stages.

2. An amplifier arrangement comprising at least two amplifier stages to which input signal voltages are applied on common, and output load means, output signal voltages from one of said two amplifier stages being arranged to be developed at one terminal of said load means and output signal voltages from the other of said two amplifier stages being arranged to be developed across said load means, whereby the sum of said ouput signal voltages is developed at the other terminal of said load means.

3. An amplifier arrangement in accordance with Claim 2 wherein said output signal voltages from said one of said two stages are developed at said one terminal of said load means by way of an emitter follower stage.

4. An amplifier arrangement in accordance with Claim 2 wherein each of said amplifier stages comprises a long tail pair stage to respective inputs of which said input signal voltages are applied in antiphase, said output signal voltages being derived in antiphase from respective output load means.

5. An amplifier arrangement comprising first and second cascoded transistor amplifier stages, means to apply input signal voltages in common to input terminals of said first and second amplifier stages, first and second resistive load means in said first and second amplifier stages across which first and second output signal voltages are developed respectively, and an emitter follower stage arranged to apply said first output signal voltage to one end of said second resistive load means such that the sum of said first and second output signal voltages is developed at the other end of said second resistive load means.

6. An amplifier arrangement in accordance with Claim 5 wherein each of said first and second amplifier stages is a long tail pair amplifier stage to inputs of which said input signal voltages are applied in antiphase.

Fig. 1.

Fig. 2.

EP 0 648 011 A1

## EUROPEAN SEARCH REPORT

**European Patent Office**

**Application Number**
EP 94 30 6383

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | US-A-4 928 073 (MINORU ARAI ET AL) * column 3, line 39 - column 5, line 4; figure 2 * | 1,2,5 | H03F3/45 |
| Y | US-A-5 017 886 (B. D. GELLER) * column 1, line 30 - line 54; figure 1 * | 1 | |
| Y | EP-A-0 156 410 (N. V. PHILIPS GLOEILAMPENFABRIEKEN) * page 11, line 16 - line 29; figure 3 * | 1 | |
| Y | EP-A-0 511 707 (PHILIPS COMPOSANTS) * abstract; figure 2 * | 1,2,5 | |
| A | US-A-4 797 629 (R. J. WIDLAR) * abstract; figure 1 * | | |
| A | US-A-4 007 427 (A. J. LEIDICH) * column 1, line 4 - line 53; figure 1 * | | |

**TECHNICAL FIELDS SEARCHED (Int.Cl.6)**

H03F

The present search report has been drawn up for all claims

| Place of search | Date of completion of the search | Examiner |
|---|---|---|
| BERLIN | 23 December 1994 | Breusing, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)